(19) Europäisches Patentamt
European Patent Office
Office européen des brevets

(11) Veröffentlichungsnummer: **0 041 677**
**B1**

(12) # EUROPÄISCHE PATENTSCHRIFT

(45) Veröffentlichungstag der Patentschrift: **27.12.84**

(51) Int. Cl.³: **G 03 C 1/70,** C 08 G 73/06, C 08 L 79/08, G 02 B 5/14 // G03F7/26, H01B3/30

(21) Anmeldenummer: **81104178.9**

(22) Anmeldetag: **01.06.81**

(54) **Strahlungsreaktive Vorstufen hochwärmebeständiger Polymerer und deren Verwendung.**

(30) Priorität: **10.06.80 DE 3021748**

(43) Veröffentlichungstag der Anmeldung: **16.12.81 Patentblatt 81/50**

(45) Bekanntmachung des Hinweises auf die Patenterteilung: **27.12.84 Patentblatt 84/52**

(84) Benannte Vertragsstaaten: **AT BE CH DE FR GB IT LI NL SE**

(56) Entgegenhaltungen:
**DE - A - 2 437 368**
**DE - B - 2 308 830**

(73) Patentinhaber: **Siemens Aktiengesellschaft, Berlin und München Wittelsbacherplatz 2, D-8000 München 2 (DE)**

(72) Erfinder: **Ahne, Hellmut, Dr., Heidestrasse 6, D-8551 Röttenbach (DE)**
Erfinder: **Kühn, Eberhard, Bergstrasse 32, D-8551 Hemhofen (DE)**
Erfinder: **Rubner, Roland, Dr., Buchenring 15, D-8551 Röttenbach (DE)**

**EP 0 041 677 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft oligomere und/oder polymere strahlungsreaktive Vorstufen von Polymeren sowie die Verwendung derartiger Vorstufen.

Vorstufen von Polymeren sind beispielsweise aus der DE-C-2 308 830 bekannt. Diese Polymer-Vorstufen sind Polyadditions- oder Polykondensationsprodukte polyfunktioneller carbocyclischer oder heterocyclischer, strahlungsempfindliche Reste tragender Verbindungen mit Diaminen, Diisocyanaten, Bis-säurechloriden oder Dicarbonsäuren. Die strahlungsempfindliche Reste tragenden Verbindungen enthalten zwei für Additions- oder Kondensationsreaktionen geeignete Carboxyl-, Carbonsäurechlorid-, Amino-, Isocyanat- oder Hydroxylgruppen und teilweise in ortho- oder peri-Stellung dazu esterartig an Carboxylgruppen gebundene strahlungsreaktive Gruppen, und die mit diesen Verbindungen umzusetzenden Diamine, Diisocyanate, Bis-säurechloride und Dicarbonsäuren weisen mindestens ein cyclisches Strukturelement auf.

Die bekannten Polymer-Vorstufen dienen zur Herstellung von Schutz- und Isolierschichten sowie von Reliefstrukturen aus hochwärmebeständigen Polymeren, in die sie durch Belichtung und gegebenenfalls durch nachfolgendes Tempern überführt werden. Dabei werden insbesondere Polymere folgender Stoffklassen erhalten: Polyimide (einschliesslich Polyamidimide und Polyesterimide), Poly-1.3-chinazolin-2.6-dione, Polyisoindolochinazolindione, Poly-1.3-oxazin-6-one und Polybenz-1.3-oxazin-2.4-dione.

Die bekannten Polymer-Vorstufen, die durch Strahlung vernetzbar und somit phototechnisch strukturierbar sind, sind in organischen Lösungsmitteln löslich. Bei der Verwendung organischer Lösungsmittel treten aber insbesondere Probleme hinsichtlich der Toxizität, der Brennbarkeit und der Quellung und Zerstörung von Dichtungswerkstoffen sowie Probleme bei der Entsorgung auf.

Aufgabe der Erfindung ist es, strahlungsreaktive Vorstufen der eingangs genannten Art bereitzustellen, bei denen die mit der Verwendung organischer Lösungsmittel verbundenen Probleme entfallen.

Dies wird erfindungsgemäss dadurch erreicht, dass die Vorstufen aus Additionsprodukten von cyclischen Carbonsäureanhydriden mit hydroxylgruppenhaltigen Verbindungen bestehen, wobei die hydroxylgruppenhaltigen Verbindungen Additionsprodukte von olefinisch ungesättigten Monoepoxiden

- an carboxylgruppenhaltige Polyadditionsprodukte aus aromatischen und/oder heterocyclischen Tetracarbonsäuredianhydriden und Diaminoverbindungen oder Diaminoverbindungen mit wenigstens einer ortho-ständigen Amidogruppe bzw. an carboxylgruppenhaltige Polyadditionsprodukte aus aromatischen und/oder heterocyclischen Dihydroxydicarbonsäuren oder entsprechenden Diaminodicarbonsäuren und Diisocyanaten oder
- an aminogruppenhaltige Polykondensationsprodukte von aromatischen und/oder heterocyclischen Tetraaminoverbindungen mit Dicarbonsäurechloriden oder -estern bzw. an aminogruppenhaltige Polyadditionsprodukte aus den Tetraaminoverbindungen und Tetracarbonsäuredianhydriden oder
- an hydroxylgruppenhaltige Polykondensationsprodukte von aromatischen und/oder heterocyclischen Dihydroxydiaminoverbindungen mit Dicarbonsäurechloriden oder -estern sind.

Die erfindungsgemässen strahlungsreaktiven Vorstufen hochwärmebeständiger Polymeren weisen die wesentliche Eigenschaft auf, dass sie in wässrig-alkalischen Lösungsmitteln gut löslich sind. Diese Eigenschaft ist insbesondere für die Resisttechnologie von Bedeutung, da hierbei nicht nur eine Verarbeitung in bzw. aus wässriger Lösung möglich ist, sondern auch die beim Einsatz organischer Lösungsmittel auftretenden Probleme entfallen. Durch die Erfindung werden erstmals reaktive Vorstufen hochwärmebeständiger Polymeren mit Negativresisteigenschaften bereitgestellt, die ähnlich wie Positivresists wässrig-alkalisch entwickelbar und somit ohne die Verwendung organischer Lösungsmittel phototechnisch strukturierbar sind. Bei der Verwendung der erfindungsgemässen Polymer-Vorstufen, die im übrigen in einfacher Weise herstellbar sind, ergeben sich also Vorteile in wirtschaftlicher und ökologischer Hinsicht.

Die erfindungsgemässen Polymer-Vorstufen eigenen sich insbesondere zur Herstellung von strukturierten hochwärmebeständigen Schutz- und Isolierschichten in der Mikroelektronik (Feinstrukturerzeugung) sowie zur Verwendung als Photoresist (vgl. dazu die gleichzeitig eingereichte europäische Patentanmeldung «Verfahren zur Herstellung hochwärmebeständiger Reliefstrukturen und deren Verwendung», Nr. 41 678).

Die erfindungsgemässen strahlungsreaktiven Vorstufen weisen im allgemeinen folgende Struktur auf:

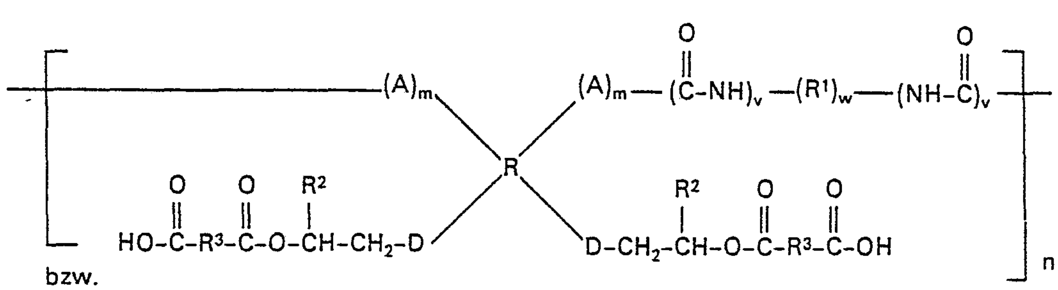

(1)

bzw.

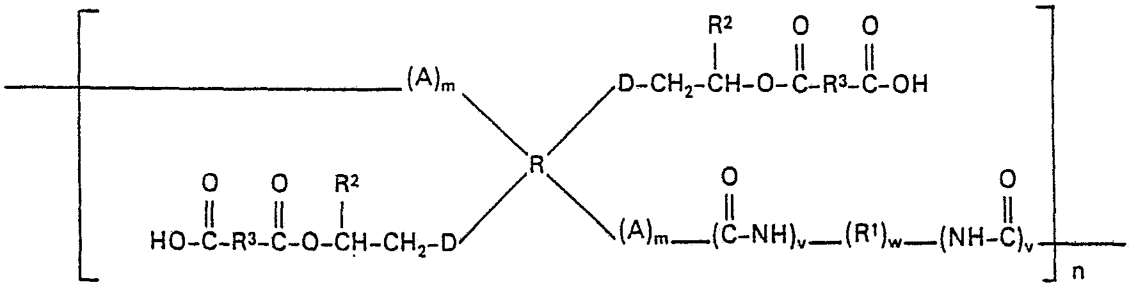

(2)

In den Formeln (1) und (2) bedeutet n eine ganze Zahl von 2 bis etwa 100; m, v und w sind 0 oder 1. Für R, $R^1$, $R^2$, $R^3$, A und D gilt folgendes:

R ist ein - gegebenenfalls halogenierter - zumindest partiell aromatischer und/oder heterocyclischer tetravalenter, d.h. tetrafunktioneller Rest, bei dem jeweils zwei Valenzen in Nachbarstellung zueinander angeordnet sind; weist der Rest R mehrere aromatische und/oder heterocyclische Strukturelemente auf, so befinden sich die Valenzpaare jeweils an endständigen derartigen Strukturelementen;

$R^1$ ist ein - gegebenenfalls halogenierter - divalenter, d.h. difunktioneller Rest aliphatischer und/oder cycloaliphatischer, gegebenenfalls Heteroatome aufweisender, und/oder aromatischer und/oder heterocyclischer Struktur;

$R^2$ ist ein olefinisch ungesättigter Rest, beispielsweise eine allylätherhaltige oder maleinimidhaltige Gruppe, und insbesondere eine - gegebenenfalls substituierte - (meth)acrylesterhaltige Gruppe;

$R^3$ ist ein - gegebenenfalls halogenierter - divalenter, d.h. difunktioneller aliphatischer und/oder cycloaliphatischer, oelfinisch ungesättigter und/oder aromatischer und/oder heterocyclischer Struktur;

A bedeutet -O-, -NH- oder $-NH-\overset{O}{\overset{\|}{C}}-$ und

D bedeutet $-\underset{\underset{O}{\|}}{C}-O-$, -O-, -S-, -NH- oder

$-\underset{|}{N}-CH_2-\underset{\underset{R^2}{|}}{CH}-O-\overset{O}{\overset{\|}{C}}-R^3-COOH.$

Dabei gilt folgendes:

Bei m = 1 und v = 1 ist A = -NH- oder -O- und D = $-\underset{\underset{O}{\|}}{C}-O-$;

bei m = 0 und v = 1 ist D = $-\underset{\underset{O}{\|}}{C}-O-$;

bei m = 1 und v = 0 ist A = $-NH-\underset{\underset{O}{\|}}{C}-$ und D = -O-,

-S-, -NH- oder $-\underset{|}{N}-CH_2-\underset{\underset{R^2}{|}}{CH}-O-\underset{\underset{O}{\|}}{C}-R^3-COOH$;

bei m = 0 und w = 0 ist v = 1.

Die Reste R, $R^1$, $R^2$ und $R^3$ haben insbesondere folgende Bedeutung:

R = 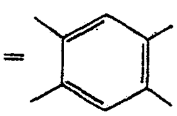 , 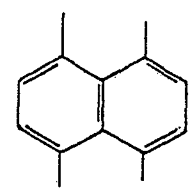 ,

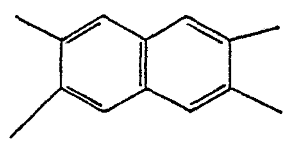 ,

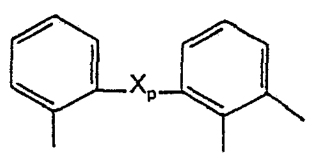 ,

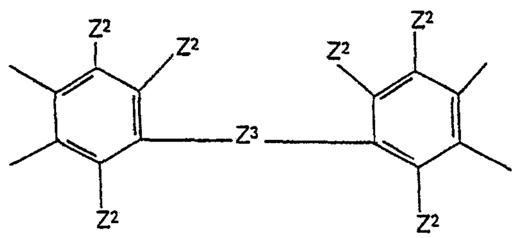 ,

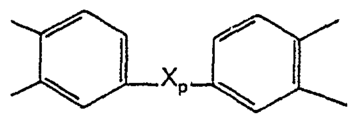

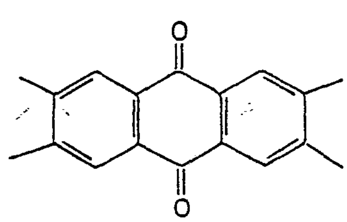 ,

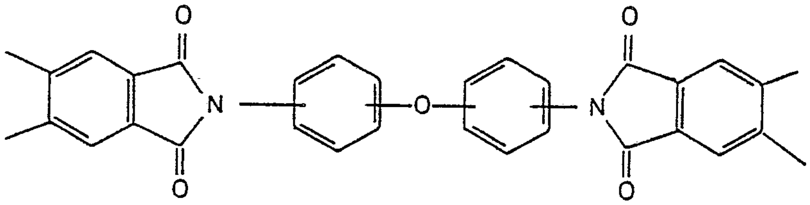 , 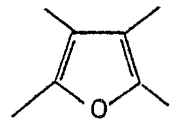 und

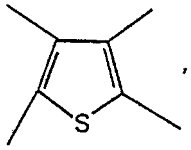 ,

wobei p = 0 oder 1 und X für einen der folgenden Reste steht.

X = -O-, 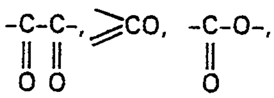 und

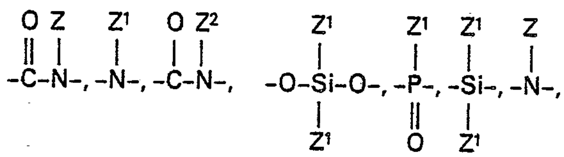

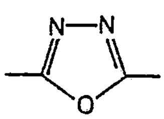 , 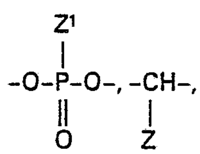

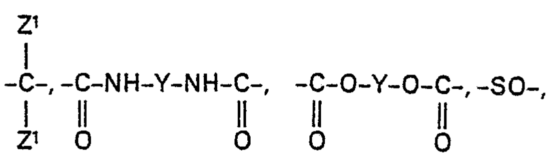

$-SO_2-$, $-SO_2NH-$, -S-, 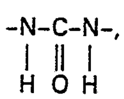 -N=N-,

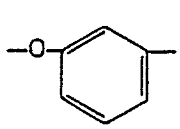 , 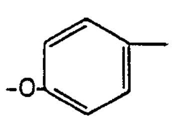 ,

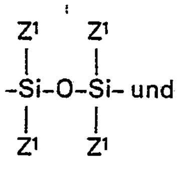 und 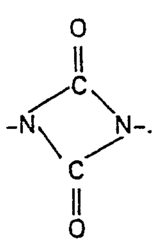

Für die weiteren Reste gilt:

Y = 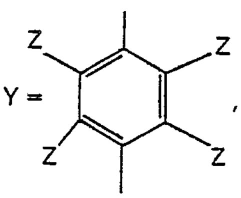 , $-(CH_2)_o-$ mit o = 2 bis 10 und

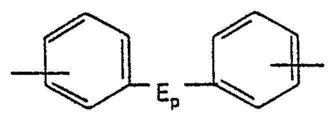 mit p = o oder 1,

Z = H oder Alkyl mit 1 bis 6 Kohlenstoffatomen,
$Z^1$ = Alkyl mit 1 bis 10 Kohlenstoffatomen oder Aryl,
$Z^2$ = Aryl oder Heteroaryl und

$Z^3$ = 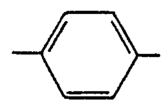 oder

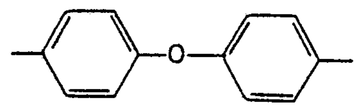 ;

E = 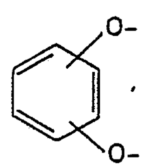 , 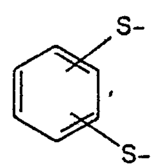 , 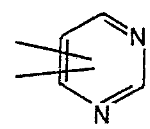 ,

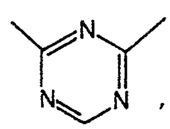 , 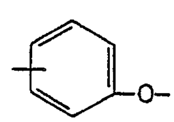 ,

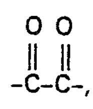 , 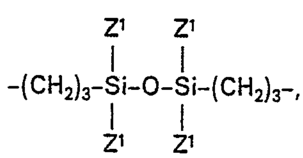

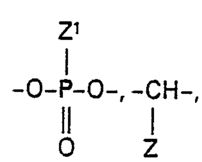 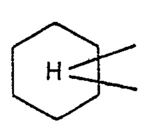 , $-(CH_2)_q-$,

$-(CF_2)_r-$, $-SO-$, $-SO_2-$, 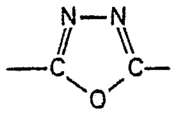 ,

$-SO_2NH-$, 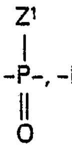, 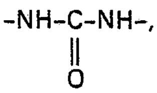, 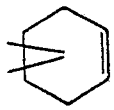

$-N{=}N-$, 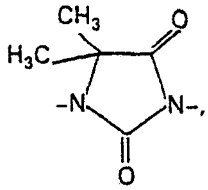 $-S-$, $-O-$,

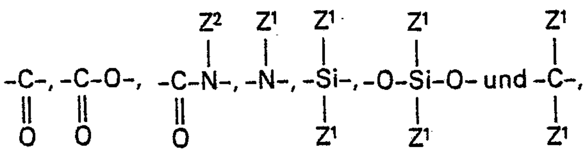

wobei q = 2 bis 14 und r = 2 bis 18, und $Z^1$ und $Z^2$ wie vorstehend definiert sind.

$R^1$ = 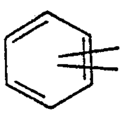 , 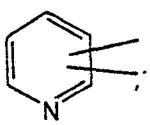 ; 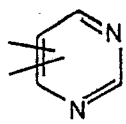 ,

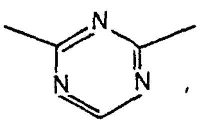 , 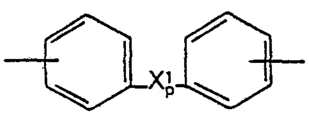 ,

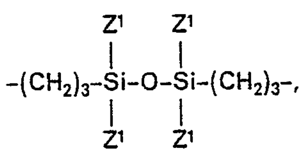 , 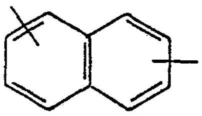 ,

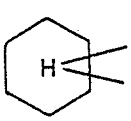 , $-(CH_2)_q-$, $-(CH_2)_r-$,

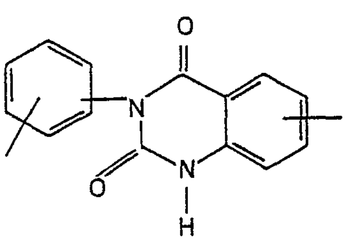 , 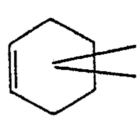 ,

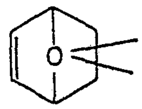 , 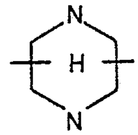 ,

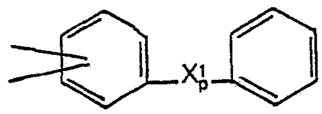 ,

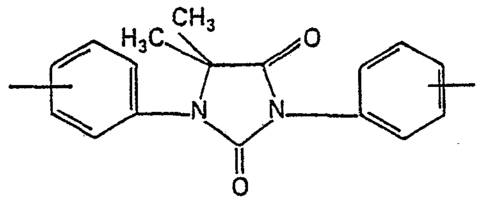 ,

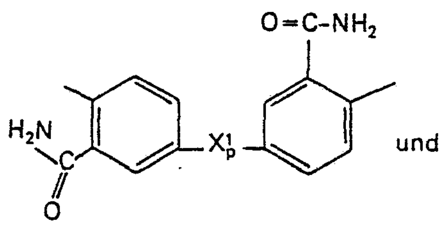 und

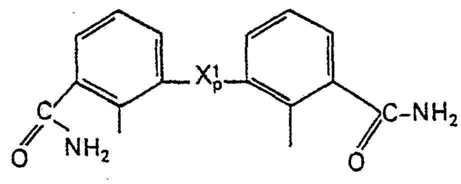 ,

wobei p = 0 oder 1, q = 2 bis 14 und r = 2 bis 18, und $Z^1$ wie vorstehend definiert ist;

$X^1$ = $-O-$, 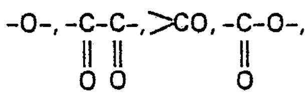

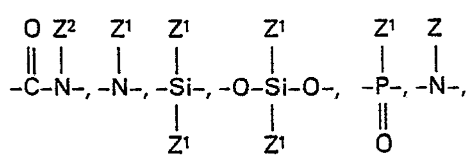

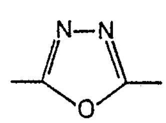 , 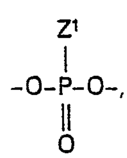, 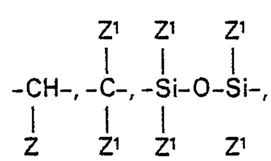

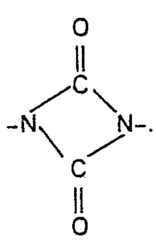 $-SO-$, $-SO_2-$, $-SO_2NH-$, $-S-$,

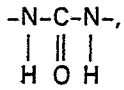 -N=N-, 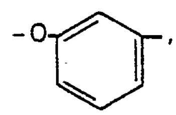, 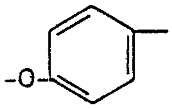

und 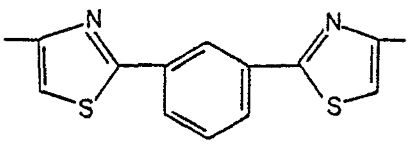,

wobei Z, $Z^1$ und $Z^2$ wie vorstehend definiert sind.

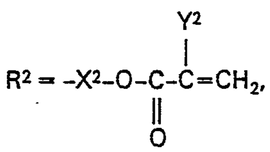

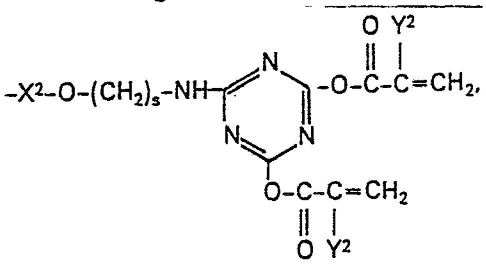

$-X^2-O-CH_2-CH=CH_2$,

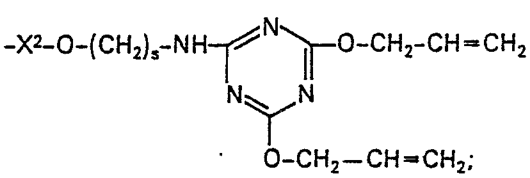 und

;

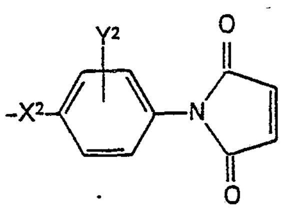 ;

dabei ist s = 2 bis 16;
für die weiteren Reste gilt:
$X^2 = -CH_2-$ und $-CH_2-O[(CH_2)_r-O]_t(CH_2)_3-$, und
$Y^2 = -H, -CH_3, -Cl, -Br$ oder $-C{\equiv}N$,
wobei r = 2 bis 18, s = 2 bis 16 und t = 1 bis 10.

$R^3 = -(CH_2)_s-, -CY^2=CY^2-$, 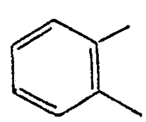

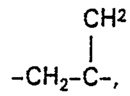, 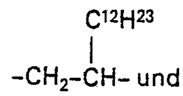 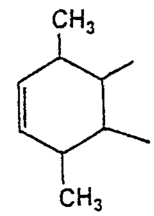 ;

dabei ist s = 2 bis 16 und $Y^2$ ist wie vorstehend definiert.

Die erfindungsgemässen strahlungsreaktiven Vorstufen sind Additionsprodukte von cyclischen Carbonsäureanhydriden mit hydroxylgruppenhaltigen Verbindungen. Die hydroxylgruppenhaltigen Verbindungen wiederum sind Additionsprodukte von olefinisch ungesättigten Monoepoxiden an carboxylgruppenhaltige bzw. aminogruppenhaltige bzw. hydroxylgruppenhaltige Prepolymere. Diese hydroxylgruppenhaltigen Verbindungen, die Vorstufen von Polyimiden, Polyisoindolochinazolindionen, Polyoxazindionen, Polychinazolindionen, Polyimidazolen, Polyimidazopyrrolonen und Polyoxazolen sind, sind Gegenstand folgender europäischer Patentanmeldungen (Veröffentlichungsnummer): Nr. 80 104 637.6 (0 027 506) - Nr. 80 104 640.0 (0 024 592) - und Nr. 80 104 643.4 (0 025 506).

An die genannten hydroxylgruppenhaltigen Verbindungen werden cyclische Carbonsäureanhydride addiert. Diese Anhydride weisen folgende Struktur (3) auf, wobei der Rest $R^3$ die vorstehend angegebene Bedeutung besitzt:

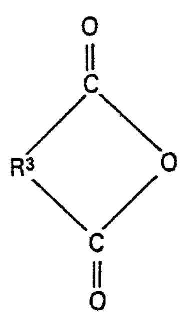 . (3)

Bevorzugt werden dabei Maleinsäureanhydride und Itaconsäureanhydrid. Weitere Anhydride sind beispielsweise Bernsteinsäureanhydrid und Phthalsäureanhydrid.

Anhand der nachfolgenden Formeln (4) bis (10) wird die Struktur der erfindungsgemässen strahlungsreaktiven Vorstufen beispielhaft verdeutlicht:

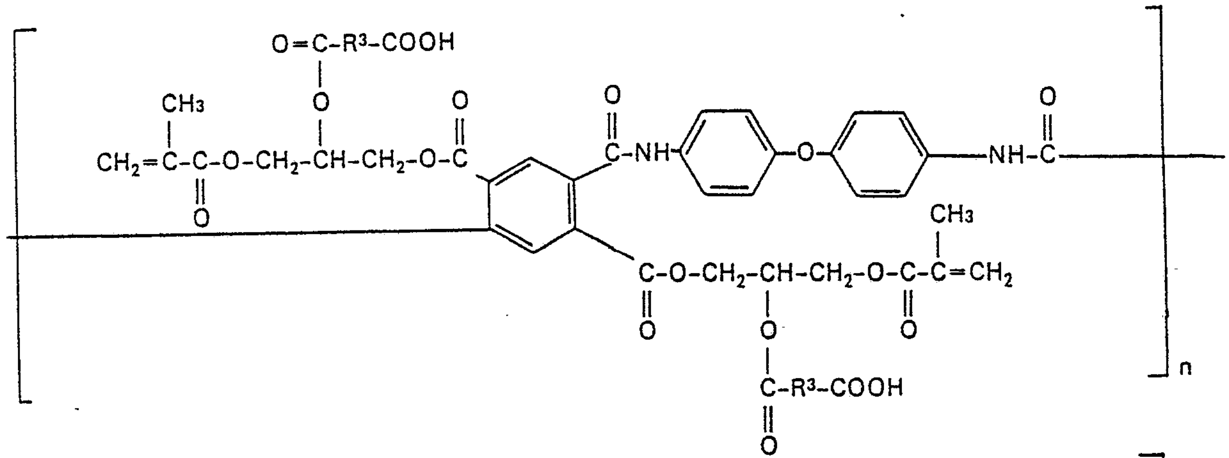

(4)

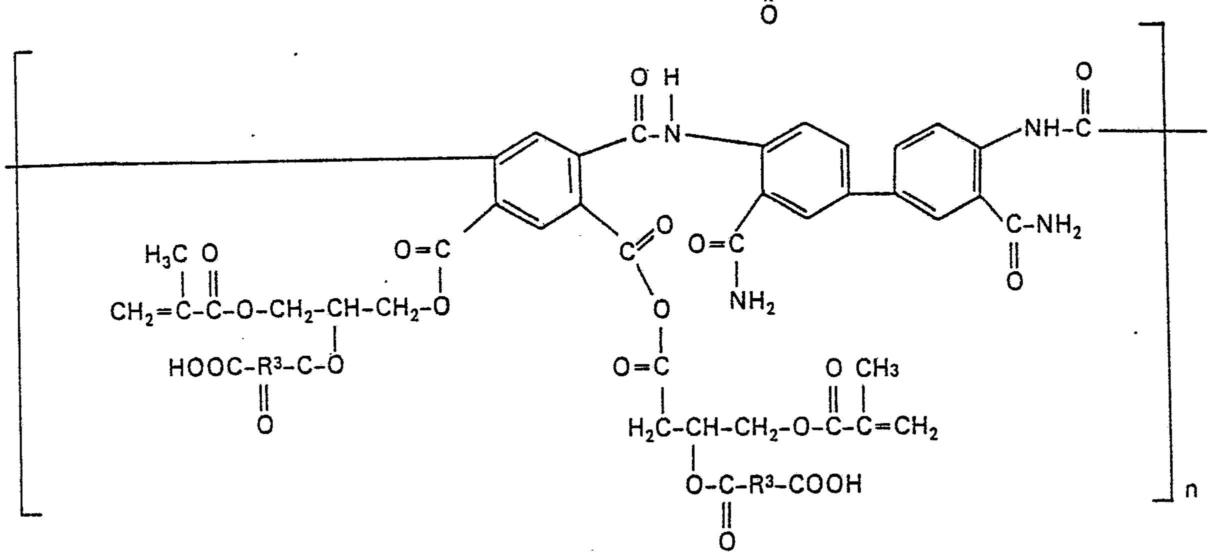

(5)

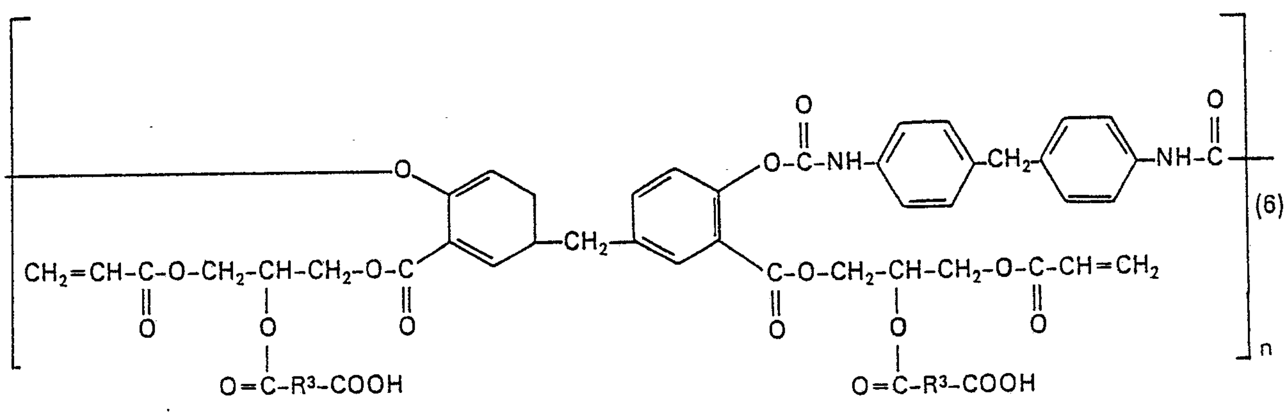

(6)

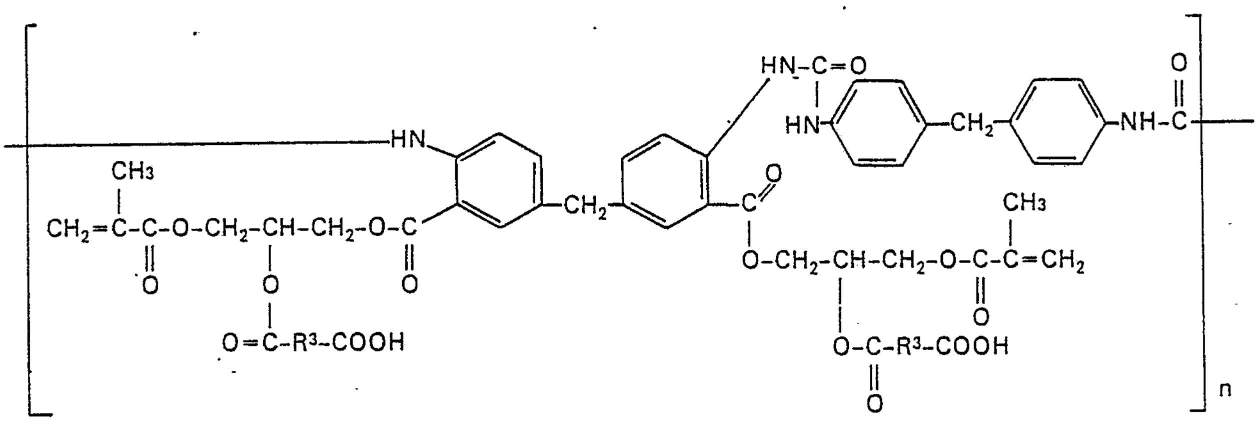

(7)

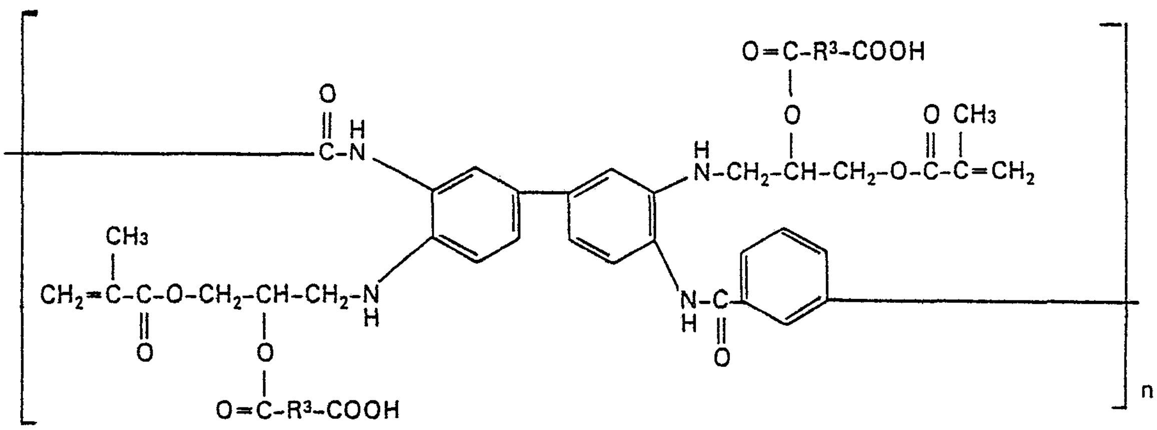

(8)

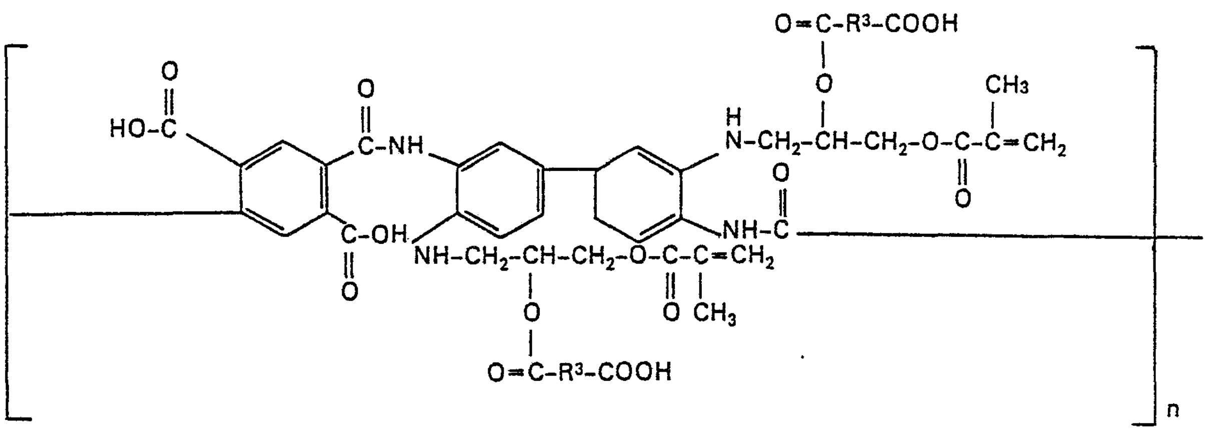

(9)

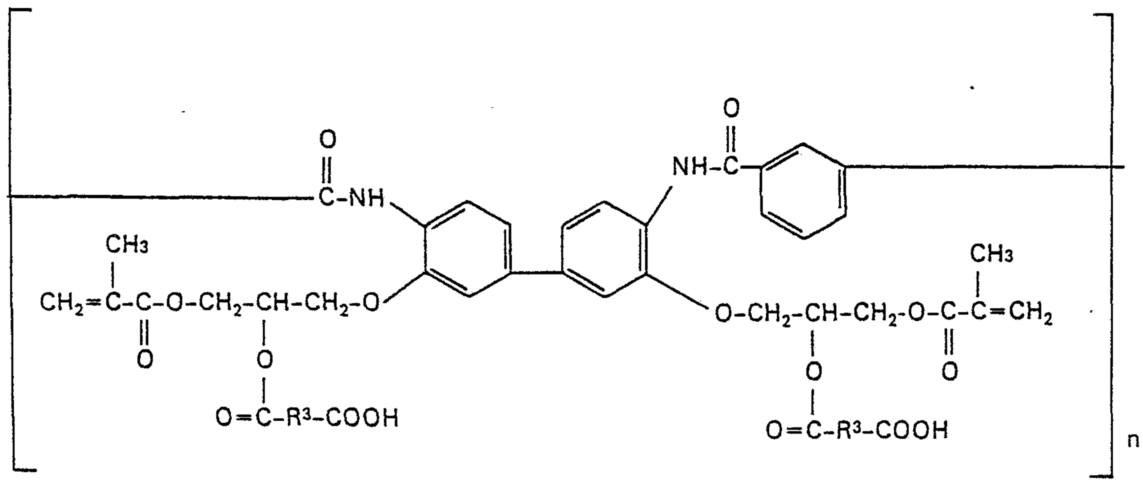

(10)

In den Formeln (4) bis (10) sind folgende strahlungsreaktive Polymer-Vorstufen dargestellt:

(4) Additionsprodukt aus einem Carbonsäureanhydrid und einer Polyimid-Vorstufe, erhalten durch Addition von Glycidylmethacrylat an das Polyadditionsprodukt aus Pyromellithsäuredianhydrid und 4.4′-Diaminodiphenyläther;
(5) Additionsprodukte aus einem Carbonsäureanhydrid und einer Polyisoindolochinazolindion-Vorstufe, erhalten durch Addition von Glycidylmethacrylat an das Polyadditionsprodukt aus Pyromellithsäuredianhydrid und 4.4′-Diaminodiphenyl-3.3′-dicarbonsäureamid;
(6) Additionsprodukt aus einem Carbonsäureanhydrid und einer Polyoxazindion-Vorstufe, und zwar speziell einer Polybenzoxazindion-Vorstufe, erhalten durch Addition von Glycidylacrylat an das Polyadditionsprodukt aus 4.4′-Dihydroxydiphenylmethan-3.3′-dicarbonsäure und 4.4′-Diphenylmethandiisocyanat;
(7) Additionsprodukt aus einem Carbonsäureanhydrid und einer Polychinazolindion-Vorstufe, erhalten durch Addition von Glycidylmethacrylat an das Polyadditionsprodukt aus 4.4′-Diaminodiphenylmethan-3.3′-dicarbonsäure und 4.4′-Diphenylmethandiisocyanat;
(8) Additionsprodukt aus einem Carbonsäureanhydrid und einer Polyimidazol-Vorstufe, und zwar speziell einer Polybenzimidazol-Vorstufe, erhalten durch Addition von Glycidylmethacrylat an das Polykondensationsprodukt aus 3.3'-Diaminobenzidin und Isophthalsäuredimethylester;

(9) Additionsprodukt aus einem Carbonsäureanhydrid und einer Polyimidazopyrrolon-Vorstufe, erhalten durch Addition von Glycidylmethacrylat an das Polyadditionsprodukt aus 3.3'-Diaminobenzidin und Pyromellithsäuredianhydrid;

(10) Additionsprodukt aus einem Carbonsäureanhydrid und einer Polyoxazol-Vorstufe, und zwar speziell einer Polybenzoxazol-Vorstufe, erhalten durch Addition von Glycidylmethacrylat an das Polykondensationsprodukt aus 3.3'-Dihydroxybenzidin und Isophthalsäuredichlorid.

Der Begriff «Polyimide» schliesst im übrigen auch Verbindungen wie Polyesterimide, Polyamidimide und Polychinazolindionimide ein. Unter «Diaminoverbindungen» sollen auch Abkömmlinge des Hydrazins verstanden werden; bei der Umsetzung derartiger Verbindungen mit Tetracarbonsäuredianhydriden entstehen sogenannte Polyhydrazide.

Ausser zur Verwendung als Photoresist und zur Herstellung von Schutz- und Isolierschichten, wobei eine Strukturierung erfolgt, können die erfindungsgemässen Vorstufen auch allgemein – in nicht-strukturierter Form – zur Herstellung von Schutz- und Isolierüberzügen dienen. Besonders vorteilhaft können diese Vorstufen dabei zur Herstellung von Kunststoffüberzügen für die Lichtleitfasern von Lichtwellenleitern verwendet werden.

Anhand von Ausführungsbeispielen soll die Erfindung noch näher erläutert werden.

Beispiel 1

Herstellung einer strahlungsreaktiven Vorstufe für Polybenzoxazol

Zu einer Lösung von 6,49 Gewichtsteilen 3.3'-Dihydroxybenzidin in 50 Volumenteilen Dimethylacetamid und 9 Volumenteilen Pyridin werden unter intensivem Rühren bei einer Temperatur von −5 bis −20°C innerhalb von etwa 30 min 6,1 Gewichtsteile Isophtalsäuredichlorid in 20 Volumenteilen Cyclohexanon getropft. Nach 3stündigem weiteren Rühren bei Raumtemperatur wird die viskose Reaktionslösung über Nacht stehengelassen, dann wird die Lösung unter Rühren in 1000 Volumenteile Wasser getropft. Das sich dabei abscheidende Harz wird abgetrennt, mit Wasser und Methanol gewaschen und im Vakuum bei ca. 60°C getrocknet.

10 Gewichtsteile des auf die beschriebene Weise hergestellten Polybenzoxazol-Prepolymeren werden in 100 Volumenteilen N-Methylpyrrolidon gelöst. Zu dieser Lösung werden 50 Volumenteile Glycidylmethacrylat, 0,5 Volumenteile Benzyldimethylamin und 0,5 Gewichtsteile Hydrochinon gegeben. Nach 2stündigem Erwärmen auf eine Temperatur von ca. 90°C wird das Reaktionsprodukt unter Rühren aus 1000 Volumenteilen Äthanol gefällt. Nach dem Trocknen im Vakuum wird ein gelbbraunes Pulver erhalten, das – im Gegensatz zum Prepolymeren – in wässrig-alkalischer Lösung nicht mehr löslich ist.

3,2 Gewichtsteile des erhaltenen Additionsproduktes werden in 35 Volumenteilen N-Methylpyrrolidin gelöst. Unter Rühren wird zu dieser Lösung 1 Gewichtsteil Itaconsäureanhydrid gegeben. Nach einer Reaktionsdauer von 20 h bei Raumtemperatur wird für 3 h auf 50 bis 60°C erwärmt. Danach wird die Reaktionslösung unter kräftigem Rühren in 500 Volumenteile Wasser getropft. Der anfallende Niederschlag wird abgesaugt und im Vakuum bei Raumtemperatur getrocknet. Das erhaltene Harz ist in 0,7%iger Natronlauge löslich. Das IR-Spektrum zeigt bei 3100 bis 3400 $cm^{-1}$ eine breite Bande, die der Carboxylgruppe zuzuordnen ist.

Beispiel 2

Herstellung einer strahlungsreaktiven Vorstufe für Polybenzimidazol

10,7 Gewichtsteile 3.3'-Diaminobenzidin werden in 95 Volumenteilen N-Methylpyrrolidin gelöst und zusammen mit 9,7 Gewichtsteilen Isophthalsäuredimethylester für 8 h auf eine Temperatur von 150 bis 175°C und anschliessend 2 Tage auf ca. 185°C erhitzt. Zu dieser Lösung werden 40 Volumenteile Glycidylmethacrylat gegeben. Nach einer Reaktionsdauer von 48 h bei Raumtemperatur und 4 h bei etwa 50 bis 60°C wird die Reaktionsmischung mit 8 Gewichtsteilen Itaconsäureanhydrid versetzt. Nach einer Reaktionsdauer von 4 Tagen bei Raumtemperatur wird das Reaktionsprodukt mit 1000 Volumenteilen Wasser ausgefällt und im Vakuum getrocknet. Das erhaltene Harz ist in wässrig-alkalischer Lösung löslich und zeigt im IR-Spektrum zwischen 3100 und 3400 $cm^{-1}$ eine breite Absorption, die der COOH-Gruppe zuzuordnen ist.

Beispiel 3

Herstellung einer strahlungsreaktiven Vorstufe für Polyimid

Zu 65,4 Gewichtsteilen Pyromellithsäuredianhydrid (0,3 Mol) in 450 Volumenteilen Dimethylacetamid werden unter Rühren 45 Gewichtsteile 4.4'-Diaminodiphenyläther (0,23 Mol) gegeben und anschliessend wird 2 h bei Raumtemperatur gerührt. Dann werden dem Reaktionsgemisch 2 Gewichtsteile Methacrylsäure-2-hydroxyäthylester (0,016 Mol) zugesetzt, um die noch vorhandenen endständigen Anhydridgruppen zu binden. Nach 2stündigem Rühren bei Raumtemperatur werden zur Reaktionslösung 150 Volumenteile Glycidylmethacrylat, 1,5 Volumenteile Benzyldimethylamin und 0,1 Gewichtsteile Hydrochinon gegeben. Anschliessend wird die Lösung unter Rühren 23 h auf eine Temperatur von 50 bis 60°C erwärmt und dann wird sie unter kräftigem Rühren zu 4000 Volumenteilen Äthanol getropft. Der dabei gebildete Niederschlag wird abgesaugt und im Vakuum bei Raumtemperatur getrocknet. Das Reaktionsprodukt ist in wässriger alkalischer Lösung nicht mehr löslich, löst sich aber in polaren organischen Lösungsmitteln. Im IR-Spektrum zeigt die Polyimid-Vorstufe eine Esterbande bei 5,8 µm.

35 Gewichtsteile der Polyimid-Vorstufe werden in 100 Volumenteilen Dimethylacetamid gelöst und dazu 10 Gewichtsteile Maleinsäureanhydrid gegeben. Nach einer Reaktionsdauer von 5 Tagen bei Raumtemperatur wird die Harzlösung mit 50 Volumenteilen Dimethylacetamid verdünnt und aus 2500 Volumenteilen Wasser gefällt. Das Harz wird mit Wasser gewaschen und im Vakuum getrocknet. Das erhaltene gelbliche Pulver ist in wässrig-alkalischer Lösung löslich. Das IR-Spektrum zeigt die COOH-Absorptionsbande bei 3100 bis 3400 $cm^{-1}$.

Beispiel 4

Herstellung einer strahlungsreaktiven Vorstufe für Polyamidimid

50 Gewichtsteile eines aus 2.6-Diaminopyridin und Trimellithsäureanhydrid hergestellten Polyamidimid-Prepolymeren werden in 100 Volumenteilen Dimethylacetamid gelöst und unter Rühren mit 0,05 Volumenteilen Benzyldimethylamin, 0,05 Gewichtsteilen Hydrochinon und 75 Volumenteilen Glycidylmethacrylat versetzt. Danach wird die Lösung 19 h auf eine Temperatur von 50 bis 60°C erwärmt und anschliessend werden 10 Gewichtsteile Phthalsäureanhydrid zugegeben. Nach einer Reaktionsdauer von 6 Tagen bei Raumtemperatur wird das Harz aus 2000 Volumenteilen Wasser gefällt und getrocknet. Das dabei erhaltene, leicht bräunliche Pulver ist in wässrig-alkalischer Lösung löslich.

Beispiel 5

Herstellung einer strahlungsreaktiven Vorstufe für Polyisoindolochinazolidin

11 Gewichtsteile 4.4'-Diaminodiphenyl-3.3'-dicarbonsäureamid werden in 120 Volumenteilen Dimethylacetamid aufgeschlämmt und unter Rühren mit 10 Gewichtsteilen Pyromellithsäuredianhydrid, gelöst in 100 Volumenteilen eines Dimethylacetamid/Dimethylformamid-Gemisches (Volumenverhältnis 1:1), versetzt. Nach 2stündigem Rühren werden zur erhaltenen Lösung 25 Volumenteile Glycidylmethacrylat, 0,5 Volumenteile Benzyldimethylamin und 0,05 Gewichtsteile Hydrochinonmonoäthyläther gegeben. Nach 25stündigem Rühren bei einer Temperatur von 60°C wird aus der Lösung mit 3000 Volumenteilen Propanol ein Harz ausgefällt und getrocknet. Dieses Harz ist in wässrigen alkalischen Lösungen nicht mehr löslich und zeigt im IR-Spektrum eine Esterbande bei 5,8 µm.

10 Gewichtsteile des Harzes werden in 100 Volumenteilen Dimethylacetamid gelöst und mit 5 Gewichtsteilen Maleinsäureanhydrid versetzt. Nach 5tägigem Stehen bei ca. 30°C wird die Reaktionslösung in 1000 Volumenteile Wasser getropft. Das ausfallende Harz wird getrocknet, wobei ein hellbraunes Pulver erhalten wird, das sich in wässrig-alkalischer Lösung löst.

Beispiel 6

Herstellung einer strahlungsreaktiven Vorstufe für Polychinazolindionimid

Aus 22 Gewichtsteilen Pyromellithsäuredianhydrid, gelöst in 200 Volumenteilen Dimethylacetamid, und 27 Gewichtsteilen 3-(p-Aminophenyl)-7-amino-2.4-(1H,3H)-chinazolindion, gelöst in 150 Volumenteilen Dimethylacetamid, wird nach einer 2stündigen Reaktionszeit bei Raumtemperatur unter Rühren ein Polychinazolindionimid-Prepolymeres erhalten.

Zur Lösung dieses Prepolymeren in Dimethylacetamid werden 2 Volumenteile Acrylsäure-2-hydroxyäthylester gegeben. Nach 1stündigem Rühren wird die Reaktionslösung mit 50 Volumenteilen Glycidylacrylat, 0,5 Volumenteilen Benzyldimethylamin und 0,05 Gewichtsteilen Hydrochinon versetzt. Nach 20stündigem Erwärmen auf eine Temperatur von ca. 60°C werden zur Lösung 10 Gewichtsteile Bernsteinsäureanhydrid gegeben. Nach einer Reaktionsdauer von 4 Tagen bei Raumtemperatur erhält man durch Ausfällen in 2000 Volumenteilen Wasser ein schwach bräunliches, in wässrig-alkalischer Lösung lösliches Harz.

Beispiel 7

Herstellung einer strahlungsreaktiven Vorstufe für Polybenzoxazindion

Zu einer Lösung von 28,8 Gewichtsteilen Methylendisalicylsäure (0,1 Mol) und 0,1 Gewichtsteilen 1.4-Diazabicyclo[2.2.2]octan (als Katalysator) in 100 Volumenteilen N-Methylpyrrolidon werden bei Raumtemperatur unter Rühren 25 Gewichtsteile p.p'-Diphenylmethandiisocyanat (0,1 Mol), gelöst in 50 Volumenteilen N-Methylpyrrolidon, langsam zugetropft. Nach einer Reaktionszeit von 20 h bei Raumtemperatur werden zu dieser Lösung unter Rühren 75 Volumenteile Glycidylacrylat und 0,1 Gewichtsteile Hydrochinon gegeben. Nach einer weiteren Reaktionszeit von 20 h bei einer Temperatur von 50 bis 60°C und 48 h bei Raumtemperatur wird das Harz mit 2000 Volumenteilen Toluol ausgefällt und im Vakuum getrocknet.

5 Gewichtsteile des getrockneten Harzes werden in 20 Volumenteilen eines Dimethylacetamid/Dioxan-Gemisches (Volumenverhältnis 1:1) gelöst und mit 1 Gewichtsteil Maleinsäureanhydrid versetzt. Nach 6tägigem Stehen bei Raumtemperatur wird durch Ausfällen in 50 Volumenteilen Wasser ein in wässrig-alkalischer Lösung lösliches Harz erhalten.

Beispiel 8

Herstellung einer strahlungsreaktiven Vorstufe für Polychinazolindion

1,4 Gewichtsteile 4.4'-Diphenylmethandiisocyanat werden bei ca. 100°C in 110 Gewichtsteilen Polyphosphorsäure gelöst und dann wird auf ca. 140°C erhitzt. Unter Stickstoff werden zur dabei erhaltenen Lösung 1,36 Gewichtsteile 4.4'-Diaminodiphenylmethan-3.3'-dicarbonsäure gegeben. Die Reaktionsmischung wird bei einer Temperatur von 150 bis 155°C für die Dauer von

5 h kräftig gerührt, nach dem Abkühlen wird mit 1000 Volumenteilen Wasser ausgefällt und das dabei erhaltene gelbbraune Produkt (2,7 Gewichtsteile) getrocknet. Das nicht strahlungsreaktive Prepolymere, eine Polyharnstoffsäure, zeigt im IR-Spektrum eine Absorption bei 1670 $cm^{-1}$, die für die Harnstoffgruppierung typisch ist. Hingegen treten keine Chinazolindionbanden auf, die bei 1730 $cm^{-1}$ liegen müssten, d.h. es hat noch keine partielle Cyclisierung stattgefunden.

2,7 Gewichtsteile der auf die beschriebene Weise erhaltenen Polyharnstoffsäure werden in 50 Volumenteilen N-Methylpyrrolidon gelöst und unter Rühren mit 0,5 Volumenteilen Benzyldimethylamin, 0,5 Gewichtsteilen Hydrochinon und 20 Volumenteilen Glycidylmethacrylat versetzt und 20 h auf eine Temperatur von ca. 60°C erwärmt. Danach wird 1 Gewichtsteil Maleinsäureanhydrid zugegeben und nach einer Reaktionsdauer von 7 Tagen bei Raumtemperatur aus 50 Volumenteilen Wasser gefällt. Das abgetrennte Harz ist praktisch farblos und in 1%iger wässriger Natronlauge löslich.

## Patentansprüche

1. Oligomere und/oder polymere strahlungsreaktive Vorstufen von Polymeren, dadurch gekennzeichnet, dass sie aus Additionsprodukten von cyclischen Carbonsäureanhydriden mit hydroxylgruppenhaltigen Verbindungen bestehen, wobei die hydroxylgruppenhaltigen Verbindungen Additionsprodukte von olefinisch ungesättigten Monoepoxiden
- an carboxylgruppenhaltige Polyadditionsprodukte aus aromatischen und/oder heterocyclischen Tetracarbonsäuredianhydriden und Diaminoverbindungen oder Diaminoverbindungen mit wenigsten einer ortho-ständigen Amidogruppe bzw. an carboxylgruppenhaltige Polyadditionsprodukte aus aromatischen und/oder heterocyclischen Dihydroxydicarbonsäuren oder entsprechenden Diaminodicarbonsäuren und Diisocyanaten oder
- an aminogruppenhaltige Polykondensationsprodukte von aromatischen und/oder heterocyclischen Tetraaminoverbindungen mit Dicarbonsäurechloriden oder -estern bzw. an aminogruppenhaltige Polyadditionsprodukte aus den Tetraaminoverbindungen und Tetracarbonsäuredianhydriden oder
- an hydroxylgruppenhaltige Polykondensationsprodukte von aromatischen und/oder heterocyclischen Dihydroxydiaminoverbindungen mit Dicarbonsäurechloriden oder -estern sind.

2. Strahlungsreaktive Vorstufen nach Anspruch 1, dadurch gekennzeichnet, dass das cyclische Carbonsäureanhydrid Maleinsäureanhydrid oder Itaconsäureanhydrid ist.

3. Strahlungsreaktive Vorstufen nach Anspruch 1 oder 2, dadurch gekennzeichnet, dass die hydroxylgruppenhaltige Verbindung eine Polyimid-Vorstufe, insbesondere ein Additionsprodukt von Glycidylmethacrylat an das Polyadditionsprodukt aus Pyromellithsäuredianhydrid und 4.4'-Diaminodiphenyläther oder ein Additionsprodukt von Glycidylacrylat an das Polyadditionsprodukt aus Benzophenontetracarbonsäuredianhydrid und 4.4'-Diaminodiphenyläther, ist.

4. Strahlungsreaktive Vorstufen nach Anspruch 1 oder 2, dadurch gekennzeichnet, dass die hydroxylgruppenhaltige Verbindung eine Polyisoindolochinazolindion-Vorstufe, insbesondere ein Additionsprodukt von Glycidylmethacrylat an das Polyadditionsprodukt aus Pyromellithsäuredianhydrid und 4.4'-Diaminodiphenyl-3.3'-dicarbonsäureamid, ist.

5. Strahlungsreaktive Vorstufen nach Anspruch 1 oder 2, dadurch gekennzeichnet, dass die hydroxylgruppenhaltige Verbindung eine Polyoxazindion-Vorstufe, insbesondere ein Additionsprodukt von Glycidylacrylat an das Polyadditionsprodukt aus 4.4'-Dihydroxydiphenylmethan-3.3'-dicarbonsäure und 4.4'-Diphenylmethandiisocyanat, ist.

6. Strahlungsreaktive Vorstufen nach Anspruch 1 oder 2, dadurch gekennzeichnet, dass die hydroxylgruppenhaltige Verbindung eine Polychinazolindion-Vorstufe, insbesondere ein Additionsprodukt von Glycidylmethacrylat an das Polyadditionsprodukt aus 4.4'-Diaminodiphenylmethan-3.3'-dicarbonsäure und 4.4'-Diphenylmethandiisocyanat, ist.

7. Strahlungsreaktive Vorstufen nach Anspruch 1 oder 2, dadurch gekennzeichnet, dass die hydroxylgruppenhaltige Verbindung eine Polyimidazol-Vorstufe, insbesondere ein Additionsprodukt von Glycidylmethacrylat an das Polykondensationsprodukt aus 3.3'-Diaminobenzidin und Isophthalsäuredichlorid oder -dimethylester, ist.

8. Strahlungsreaktive Vorstufen nach Anspruch 1 oder 2, dadurch gekennzeichnet, dass die hydroxylgruppenhaltige Verbindung eine Polyimidazopyrrolon-Vorstufe, insbesondere ein Additionsprodukt von Glycidylmethacrylat an das Polyadditionsprodukt aus 3.3'-Diaminobenzidin und Pyromellithsäuredianhydrid, ist.

9. Strahlungsreaktive Vorstufen nach Anspruch 1 oder 2, dadurch gekennzeichnet, dass die hydroxylgruppenhaltige Verbindung eine Polyoxazol-Vorstufe, insbesondere ein Additionsprodukt von Glycidylmethacrylat an das Polykondensationsprodukt aus 3.3'-Dihydroxybenzidin und Isophthalsäuredichlorid oder -dimethylester, ist.

10. Verwendung der strahlungsreaktiven Vorstufen nach einem oder mehreren der Ansprüche 1 bis 9 zur Herstellung von Kunststoffüberzügen für die Lichtleitfasern von Lichtwellenleitern.

## Revendications

1. Précurseurs de polymères oligomeres et/ou polymères, réactifs au rayonnement, caractérisés en ce que ce sont des produits d'addition d'anhydrides d'acide carboxylique cyclique et de composés hydroxylés, les composés hydroxylés étant des produits d'addition de monoépoxydes insaturés oléfiniquement

- sur des produits de polyaddition carboxylés constitués à partir de dianhydrides d'acides tétracarboxyliques aromatiques et/ou hétérocycliques et de composés diamino ou de composés diamino ayant au moins un groupe amido en position ortho ou sur des produits de polyaddition carboxylés constitués à partir d'acides dihydroxydicarboxyliques aromatiques et/ou hétérocycliques ou d'acides diaminodicarboxyliques correspondants et de diisocyanates ou

- sur des produits de polycondensation aminés de composés tétraamino aromatiques et/ou hétérocycliques et de chlorures d'acide dicarboxylique ou d'esters d'acide dicarboxylique ou sur des produits de polyaddition aminés constitués à partir de composés tétraamino et de dianhydrides d'acides tétracarboxyliques ou

- sur des produits de polycondensation hydroxylés de composés dihydroxydiamino aromatiques et/ou hétérocycliques et de chlorures d'acide dicarboxylique ou d'esters d'acide dicarboxylique.

2. Précurseurs réactifs au rayonnement suivant la revendication 1, caractérisés en ce que l'anhydride d'acide carboxylique cyclique est l'anhydride d'acide maléique ou l'anhydride d'acide itaconique.

3. Précurseurs réactifs au rayonnement suivant la revendication 1 ou 2, caractérisés en ce que le composé hydroxylé est un précurseur de polyimide, notamment un produit d'addition de méthacrylate de glycidyle sur le produit de polyaddition constitué de dianhydride d'acide pyromellithique et d'éther 4,4'-diaminodiphénylique, ou un produit d'addition d'acrylate de glycidyle sur le produit de polyaddition constitué de dianhydride d'acide benzophénontétracarboxylique et d'éther 4,4'-diaminodiphénylique.

4. Précurseurs réactifs au rayonnement suivant la revendication 1 ou 2, caractérisés en ce que le composé hydroxylé est un précurseur de polyisoindoloquinazolinodione, notamment un produit d'addition de methacrylate de glycidyle sur le produit de polyaddition constitué de dianhydride d'acide pyromellithique et de l'amide d'acide 4,4'-diaminodiphényl-3,3'-dicarboxylique.

5. Précurseurs réactifs au rayonnement suivant la revendication 1 ou 2, caractérisés en ce que le composé hydroxylé est un précurseur de polyoxazinodione, notamment un produit d'addition d'acrylate de glycidyle sur le produit de polyaddition constitué d'acide 4,4'-dihydroxydiphénylméthane-3,3'-dicarboxylique et de 4,4'-diisocyanate de diphénylméthane.

6. Précurseurs réactifs au rayonnement suivant la revendication 1 ou 2, caractérisés en ce que le composé hydroxylé est un précurseur de polyquinazolinodione, notamment un produit d'addition de méthacrylate de glycidyle sur le produit de polyaddition constitué de l'acide 4,4'-diaminodiphénylméthane-3,3'-dicarboxylique et de 4,4'-diisocyanate de diphénylméthane.

7. Précurseurs réactifs au rayonnement suivant la revendication 1 ou 2, caractérisés en ce que le composé hydroxylé est un précurseur de polyimidazole, notamment un produit d'addition de méthacrylate de glycidyle sur le produit de polycondensation constitué de 3,3'-diaminobenzidine et de dichlorure d'acide isophtalique ou d'ester diméthylique d'acide isophtalique.

8. Précurseurs réactifs au rayonnement suivant la revendication 1 ou 2, caractérisés en ce que le composé hydroxylé est un précurseur de polyimidazopyrrolone, notamment un produit d'addition de méthacrylate de glycidyle sur le produit de polyaddition constitué de 3,3'-diaminobenzidine et de dianhydride d'acide pyromellithique.

9. Précurseurs réactifs au rayonnement suivant la revendication 1 ou 2, caractérisés en ce que le composé hydroxylé est un précurseur de polyoxazole, notamment un produit d'addition de méthacrylate de glycidyle sur le produit de polycondensation constitué de 3,3'-dihydroxybenzidine et de dichlorure d'acide isophtalique ou d'ester diméthylique d'acide isophtalique.

10. Utilisation des précurseurs réactifs au rayonnement suivant l'une ou plusieurs des revendications 1 à 9, pour la préparation de revêtements en matière plastique, destinés à des fibres optique de conducteurs d'ondes lumineuses.

**Claims**

1. Oligomeric and/or polymeric radiation-reactive polymer precursors, characterised in that they consist of addition products of cyclic carboxylic acid anhydrides with compounds containing hydroxyl groups, where the compounds which contain hydroxyl groups are addition products of olefinically-unsaturated monoepoxides

- with carboxyl group-containing polyaddition products of aromatic and/or heterocyclic tetracarboxylic acid dianhydrides with diamino compounds, or diamino compounds with at least one ortho-positioned amido group; or carboxyl group-containing polyaddition products of aromatic and/or heterocyclic dihydroxydicarboxylic acids, or corresponding diaminodicarboxylic acids, with diisocyanates; or

- with amino group-containing polycondensation products of aromatic and/or heterocyclic tetraamino compounds with dicarboxylic acid chlorides or esters; or amino group-containing polyaddition products of the tetraamino compounds with tetracarboxylic acid dianhydrides; or

- with hydroxyl group-containing polycondensation products of aromatic and/or heterocyclic dihydroxydiamino compounds with dicarboxylic acid chlorides or esters.

2. Radiation-reactive precursors as claimed in Claim 1, characterised in that the cyclic carboxylic acid anhydride is maleic acid anhydride, or itaconic acid anhydride.

3. Radiation-reactive precursors as claimed in Claim 1 or Claim 2, characterised in that the compound which contains hydroxyl groups is a polyimide precursor, in particular an addition product of glycidyl methacrylate with the polyaddition

product of pyromellitic acid dianhydride and 4.4'-diaminodiphenyl ether, or an addition product of glycidyl acrylate with the polyaddition product of benzophenone tetracarboxylic acid dianhydride and 4.4'-diaminodiphenyl ether.

4. Radiation-reactive precursors as claimed in Claim 1 or Claim 2, characterised in that the compound which contains hydroxyl groups is a polyisoindoloquinazolinedione precursor, in particular an addition product of glycidyl methacrylate with the polyaddition product of pyromellitic acid dianhydride and 4.4'-diaminodiphenyl-3.3'-dicarboxylic acid amide.

5. Radiation-reactive precursors as claimed in Claim 1 or Claim 2, characterised in that the compound which contains hydroxyl groups is a polyoxazinedione precursor, in particular an addition product of glycidyl acrylate with the polyaddition product of 4.4'-dihydroxydiphenylmethane-3.3'-dicarboxylic acid and 4.4'-diphenylmethane diisocyanate.

6. Radiation-reactive precursors as claimed in Claim 1 or Claim 2, characterised in that the compound which contains hydroxyl groups is a polyquinazolinedione precursors, in particular an addition product of glycidyl methacrylate with the polyaddition product of 4.4'-diaminodiphenylmethane-3.3'-dicarboxylic acid and 4.4'-diphenylmethane diisocyanate.

7. Radiation-reactive precursors as claimed in Claim 1 or Claim 2, characterised in that the compound which contains hydroxyl groups is a polyimidazole precursors, in particular an addition product of glycidyl methacrylate with the polycondensation product of 3.3'-diaminobenzidine and isophthalic acid dichloride or dimethyl ester.

8. Radiation-reactive precursors as claimed in Claim 1 or Claim 2, characterised in that the compound which contains hydroxyl groups is a polyimidazopyrrolone precursor, in particular an addition product of glycidyl methacrylate with the polyaddition product of 3.3'-diaminobenzidine and pyromellitic acid dianhydride.

9. Radiation-reactive precursors as claimed in Claim 1 or Claim 2, characterised in that the compound which contains hydroxyl groups is a polyoxazole precursors, in particular an addition product of glycidyl methacrylate with the polycondensation product of 3.3'-dihydroxybenzidine and isophthalic acid dichloride or dimethyl ester.

10. Use of the radiation-reactive precursors as claimed in one or more of Claims 1 to 9 for the production of synthetic resin coatings for the lightconducting fibres of light waveguides.